# EUROPÄISCHE PATENTSCHRIFT

(11) **EP 2 672 278 B1**
(45) Veröffentlichungstag und Bekanntmachung des Hinweises auf die Patenterteilung: **08.10.2014**
(21) Anmeldenummer: 13169089.3
(22) Anmeldetag: 24.05.2013
(51) Int. Cl.: G01R 1/067, G01R 19/155, G01R 1/04

(54) **Messinstrument, insbesondere Spannungsprüfer**
Measuring instrument, in particular a voltage tester
Instrument de mesure, notamment contrôleur de tension

(30) Priorität: 04.06.2012 DE 202012102032 U
(43) Veröffentlichungstag der Anmeldung: 11.12.2013
(73) Patentinhaber: Weidmüller Interface GmbH & Co. KG, 32758 Detmold (DE)
(72) Erfinder: Rother, Grit, 32657 Lemgo (DE); Giese, Andreas, 32756 Detmold (DE); Ehlers, Herbert, 32825 Blomberg (DE); Topp, Lars, 32758 Detmold (DE); Kühne, Lars, 33102 Paderborn (DE); Herzog, Armin, 32756 Detmold (DE)
(74) Vertreter: Specht, Peter

(56) Entgegenhaltungen:
- DE-A1- 2 912 826
- FR-A1- 2 575 837
- US-A- 3 515 989

## Beschreibung

Die vorliegende Erfindung betrifft ein sehr leicht handhabbares Messinstrument.

Es sind Messinstrumente bekannt, deren Tastköpfe durch ausreichend lange Verbindungskabel miteinander verbunden sind, so dass der Prüfer sich das Kabel umhängen kann. Der Prüfer kann das Messinstrument daher auch dann bequem bei sich führen, wenn er gerade keine Messung durchführt.

Solche Messinstrumente sind beispielsweise Spannungsprüfer oder Universalmessinstrumente, mit denen beispielsweise Spannungen, Ströme, Leistungen, Widerstände und/oder ein Leitungsdurchgang prüfbar sind.

Bei diesen Messinstrumenten sind zumeist zwei Tastköpfe in separaten Gehäusen angeordnet, die durch das Kabel miteinander verbunden sind. Das Messinstrument wird so gehandhabt, dass die Tastköpfe jeweils in eine Hand genommen werden. Beim Messen ist der Abstand der Tastköpfe voneinander somit unmittelbar händisch einstellbar.

Die Druckschrift US 3,515,989 offenbart ein solches Messinstrument mit zwei in separaten Gehäusen angeordneten Tastköpfen, bei dem an jedem der beiden Gehäuseteile jeweils ein Stabmagnet angeordnet ist. Dabei ist die Anordnung der Stabmagnete der Gehäuse korrespondierend zueinander vorgesehen, so dass der magnetische Nordpol des einen Stabmagneten dem magnetischen Südpol des anderen Stabmagneten gegenüber liegt. Diese Anordnung ermöglicht eine einhändige Handhabung des Messinstrumentes.

Die Druckschrift FR 2 575 837 A1 offenbart einen Durchgangsprüfer mit zwei in separaten Gehäusen angeordneten Tastköpfen. In den Gehäusen sind jeweils ein Magnet und ein magnetisierbares Material komplementär zueinander angeordnet, so dass die Gehäuse aneinander anhaftbar sind.

Und die Druckschrift DE 29 12 826 A1 offenbart ein solches Prüfgerät mit zwei in separaten Gehäusen angeordneten Tastköpfen, wobei an jedem der Gehäuse jeweils ein gegenüber dem Gehäuse erhabener Magnet angeordnet ist. Dadurch sind auch diese Gehäuse mittels der Magnete aneinander anhaftbar.

Die Erfindung hat die Aufgabe, die Handhabbarkeit eines solchen Messinstrumentes weiter zu verbessern.

Die Aufgabe wird durch die Merkmale des Patentanspruchs 1 gelöst. Weitere vorteilhafte Ausgestaltungen der Erfindung sind den Unteransprüchen zu entnehmen.

Das erfindungsgemäße Messinstrument weist zwei Tastköpfe auf, die in separaten Gehäusen angeordnet sind, sowie ein Kabel, an dem die Gehäuse angeordnet sind, wobei die Gehäuse sich magnetisch anziehend ausgebildet sind. Im ungenutzten Zustand können die Gehäuse daher aneinander gelegt werden und haften aneinander. Ein Verlieren des umgehängten Messinstrumentes, beispielsweise während des Gehens, wird daher erschwert. Diese Ausbildung der Gehäuse hat zudem den Vorteil, dass das Lösen der Gehäuse voneinander während einer Messung gegen die magnetische Anziehungskraft erfolgt. Es hat sich gezeigt, dass die Handhabung des Messinstrumentes dadurch leichter ist.

Bevorzugt weisen die Messinstrumente ein Tastkopfende auf, an dem jeweils die Tastköpfe zugänglich sind.

In einer bevorzugten Ausführungsform ist an zumindest einem der Gehäuse ein Magnet angeordnet, wobei zumindest ein Teil des anderen Gehäuses aus einem magnetisch leitfähigen Material gefertigt ist. In dieser Ausführungsform ist die magnetische Anziehungskraft zwischen den Gehäusen durch nur einen Magneten herstellbar. In einer ebenfalls bevorzugten Ausführungsform ist an jedem der Gehäuse jeweils ein Magnet vorgesehen, wobei die Magnete gegensätzlich zueinander gepolt vorgesehen sind. In dieser Ausführungsform sind die Magnete bevorzugt korrespondierend zueinander an den Gehäusen angeordnet, so dass ihr Abstand zum Tastkopfende gleich ist. Aufgrund ihrer gegensätzlichen Polung ziehen sich diese Magnete an, so dass die Gehäuse zueinander hin gezogen werden.

In einer weiteren bevorzugten Ausführungsform sind an einem oder beiden Gehäusen jeweils zwei voneinander beabstandete Magnete vorgesehen. Bei dieser Anordnung ist es bevorzugt, die Anziehungskraft der beiden Magnete so aufeinander abzustimmen, dass ein Abrollen der Gehäuse am Tastkopfende dadurch leichter ist. Dafür ist die Anziehungskraft des oder der weiter vom Tastkopfende beabstandeten Magnete bevorzugt größer, als die Anziehungskraft des oder der näher zum Tastkopfende angeordneten Magnete.

Bevorzugt sind korrespondierend zur Anordnung der Magnete des einen Gehäuses an dem anderen Gehäuse Ausnehmungen im Gehäusemantel vorgesehen. Dabei weisen die Ausnehmungen bevorzugt jeweils vom Tastkopfende denselben Abstand auf, wie der zu ihnen korrespondierende Magnet. Beim Fügen der Gehäuse aneinander beziehungsweise bei aneinander gefügten Gehäusen greifen die Magnete des einen Gehäuses daher in die ihnen korrespondierende Ausnehmung des anderen Gehäuses. Durch die Ausnehmungen sind entweder ein elektrisch leitender Teil des anderen Gehäuses oder andere Magnete zugänglich.

Das Messinstrument zeichnet sich dadurch aus, dass am Tastkopfende beider Gehäuse eine Abrollkante vorgesehen ist. Die Abrollkante ermöglicht ein Abrollen der Gehäuse gegeneinander. Der Abstand der Tastköpfe voneinander ist daher durch Abrollen der Gehäuse voneinander einstellbar. Dies ist in Abhängigkeit von den Gehäuseausmaßen gegebenenfalls auch einhändig möglich.

Nachfolgend wird die Erfindung unter Bezug auf die Figuren näher beschrieben. Die Figuren sind lediglich beispielhaft und schränken den allgemeinen Erfindungsgedanken nicht ein. Es zeigen:
- Fig. 1: ein erfindungsgemäßes Messinstrument, hier einen Spannungsprüfer, in erster Stellung; und
- Fig. 2: ein erfindungsgemäßes Messinstrument, hier einen Spannungsprüfer, in einer zweiten Stellung.

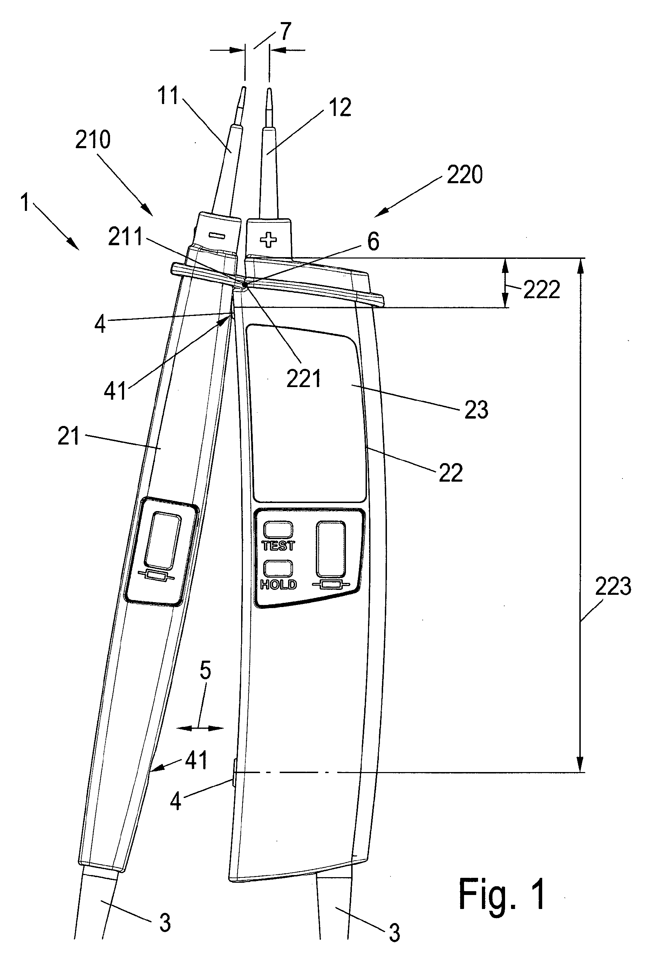

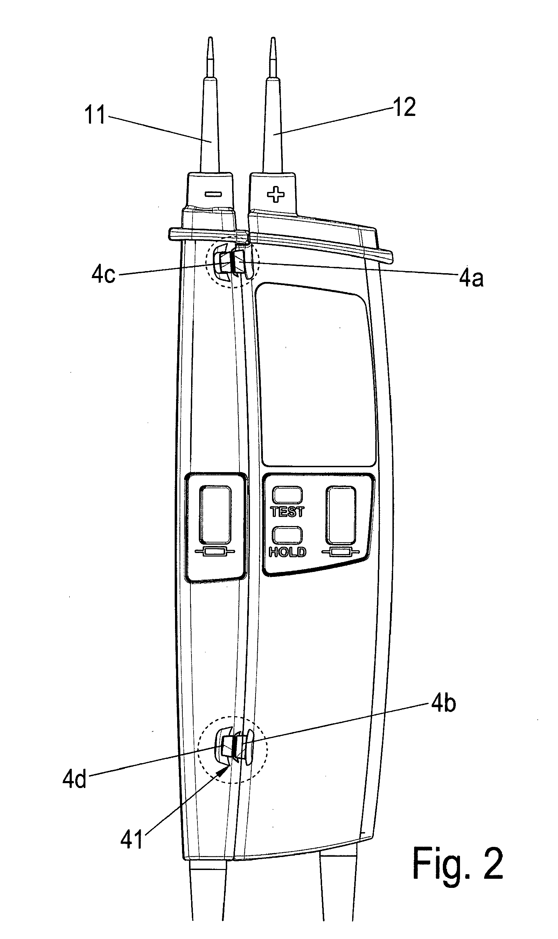

Die Fig. 1 und 2 zeigen ein Messinstrument 1, hier einen Spannungsprüfer. Das Messinstrument 1 weist zwei Tastköpfe 11, 12 auf, die jeweils in einem Gehäuse 21, 22 angeordnet sind. In den Gehäusen 21, 22 ist zudem Messelektronik (nicht gezeigt) zur Verarbeitung einer Messung angeordnet, die elektrisch leitend mit dem jeweiligen Tastkopf des Gehäuses verbunden ist.

Die Gehäuse 21, 22 sind durch ein Kabel 3 miteinander verbunden, wobei die im Kabel 3 angeordneten elektrischen Leiter (nicht gezeigt) die Messelektroniken in den Gehäusen 21, 22 elektrisch leitend miteinander verbinden.

Die Gehäuse 21, 22 sind bevorzugt zumindest teilweise aus einem elektrisch isolierenden Material hergestellt.

Elektrisch leitende Gehäuseteile sind bevorzugt mit einem Gehäusemantel aus einem elektrisch isolierenden Material ummantelt. Sie weisen jeweils ein Tastkopfende 210, 220 auf, an dem die Tastköpfe 11, 12 zugänglich sind.

Am Tastkopfende 210, 220 ist an beiden Gehäusen 21, 22 jeweils eine Abrollkante 211, 221 vorgesehen. Die Abrollkanten 211, 221 der Gehäuse 21, 22 sind korrespondierend zueinander ausgebildet, so dass die Gehäuse 21, 22 an den Abrollkanten 211, 221 um eine Abrollachse 6 gegeneinander abrollbar sind. Dafür weist das eine der beiden Gehäuse 22 als Abrollkante 221 eine abgerundete Innenkante und das andere der beiden Gehäuse 21 als Abrollkante 211 eine zu der abgerundeten Innenkante korrespondierend abgerundete Außenkante auf, die um die Abrollachse 6 gegeneinander abrollbar sind. Die abgerundete Innenkante 221 ist dabei durch eine am einen Gehäuse 22 vorgesehene nutförmige Ausnehmung gebildet, die abgerundete Außenkante 211 durch eine stegförmige Anformung am anderen Gehäuse 21. Wie ein Vergleich der Fig. 1 und 2 zeigt, kann derart der Abstand der Tastköpfe 11, 12 bzw. -spitzen auf einfache Weise verändert werden, wobei sich jeweils doch eine gut und stabil handhabbare Anordnung ergibt, welche es ermöglicht, dass die Tastköpfe 11, 12 präzise an Anschlüsse anzulegen oder beispielsweise in Buchsen von Steckdosen einzuführen sind.

An einem der beiden Gehäuse 21, 22 oder an beiden Gehäusen 21, 22 sind zwei voneinander beabstandete Magnete 4, 4a-d angeordnet. Das Messinstrument 1 mit zwei voneinander beabstandeten Magneten 4 an einem Gehäuse 22 zeigt die Fig. 1. Das Messinstrument 1 mit jeweils zwei voneinander beabstandeten Magneten 4a-d an jedem der beiden Gehäuse 21, 22 zeigt die Fig. 2.

Dieses Gehäuse 22 ist daher magnetisch anziehend ausgebildet. Korrespondierend zur Anordnung der Magnete 4, 4a, b sind an dem anderen Gehäuse 21 Ausnehmungen 41 im Gehäusemantel vorgesehen, durch die ein elektrisch leitender Teil des Gehäuses 21 zugänglich ist, oder andere, entgegengesetzt gepolte Magnete 4c, d an dem anderen Gehäuse 21, insbesondere in der Ausnehmung 41. Die Ausnehmungen 41 weisen daher jeweils vom Tastkopfende 210, 220 denselben Abstand 222, 223 auf, wie der zu ihnen korrespondierende Magnet 4, 4a, b.

Die Magnete 4a, b des einen Gehäuses 22 ziehen daher das andere Gehäuse 21 mit einer Anziehungskraft an oder die anderen, entgegengesetzt gepolten Magnete 4c, d an dem anderen Gehäuse, insbesondere in der Ausnehmung 41.

Der Abstand 7 der Tastköpfe 11, 12 voneinander ist daher durch Abrollen der Gehäuse 21, 22 an den Abrollkanten 211, 221 in eine Betätigungsrichtung 5 gegen die Anziehungskraft der Magnete 4, 4a-d, und gegen die Betätigungsrichtung 5 mit der Anziehungskraft der Magnete 4, 4a-d möglich.

Das Messinstrument 1 ist daher sehr gut handhabbar.

### Bezugszeichenliste

- 1: Messinstrument, Spannungsprüfer
- 11, 12: Tastköpfe
- 21, 22: Gehäuse
- 210, 220: Tastkopfende
- 211, 221: Abrollkante
- 222, 223: Abstand der Magnete vom Tastkopfende
- 3: Kabel
- 4, 4a-d: Magnet
- 41: Ausnehmung
- 5: Betätigungsrichtung
- 6: Abrollachse
- 7: Abstand der Tastköpfe voneinander

## Patentansprüche

1. Messinstrument (1), insbesondere Spannungsprüfer, mit zwei Tastköpfen (11, 12), die in separaten Gehäusen (21, 22) angeordnet sind, sowie mit einem Kabel (3), an dem die Gehäuse (21, 22) angeordnet sind, wobei die Spannungsprüfer, insbesondere deren Gehäuse (21, 22), sich magnetisch anziehend ausgebildet sind, wobei entweder an zumindest einem der Gehäuse (21, 22) ein Magnet (4) angeordnet, und zumindest ein Teil des anderen Gehäuses (21, 22) aus einem magnetisch leitfähigen Material gefertigt ist, oder an jedem der Gehäuse (21, 22) jeweils ein Magnet (4a-d) vorgesehen ist, wobei die Magnete (4a-d) gegensätzlich zueinander gepolt vorgesehen sind, wobei korrespondierend zur Anordnung der Magnete (4, 4a, 4b) an dem anderen Gehäuse (21) Ausnehmungen (41) im Gehäusemantel vorgesehen sind, wobei die Gehäuse (21, 22) jeweils ein Tastkopfende (210, 220) aufweisen, an dem jeweils die Tastköpfe (11, 12) zugänglich sind,
**dadurch gekennzeichnet, dass**
am Tastkopfende (210, 220) beider Gehäuse (21, 22) eine Abrollkante (211, 221) vorgesehen ist, wobei die Abrollkanten (211, 221) korrespondierend ausgebildet sind und ein Abrollen der Gehäuse (21, 22) aneinander ermöglichen.

2. Messinstrument (1) nach Anspruch 1, **dadurch gekennzeichnet, dass** durch die Ausnehmungen (41) entweder der magnetisch leitende Teil des anderen Gehäuses (21) zugänglich ist, oder andere, entgegengesetzt gepolte Magnet (4c, d) an dem anderen Gehäuse (21).

3. Messinstrument (1) nach einem der vorherigen Ansprüche, **dadurch gekennzeichnet, dass** die Ausnehmungen (41) jeweils vom Tastkopfende (210, 220) denselben Abstand (222, 223) aufweisen, wie der zu ihnen korrespondierende Magnet (4, 4a, b).

4. Messinstrument (1) nach Anspruch 1, **dadurch gekennzeichnet, dass** die Gehäuse (21, 22) an den Abrollkanten (211, 221) um eine Abrollachse (6) gegeneinander abrollbar sind.

5. Messinstrument (1) nach Anspruch 1, **dadurch gekennzeichnet, dass** an jedem der Gehäuse (21, 22) jeweils wenigstens ein Magnet (4a-d) vorgesehen ist, wobei die Magnete (4a-d) gegensätzlich zueinander gepolt vorgesehen sind, und wobei die Magnete (4a-d) korrespondierend zueinander an den Gehäusen (21, 22) angeordnet sind.

6. Messinstrument (1) nach einem der vorherigen Ansprüche, **dadurch gekennzeichnet, dass** an einem oder beiden Gehäusen (21, 22) jeweils zwei voneinander beabstandete Magnete (4, 4a-d) vorgesehen sind.

7. Messinstrument (1) nach einem der vorherigen Ansprüche, **dadurch gekennzeichnet, dass** die Anziehungskraft des oder der weiter vom Tastkopfende (210, 220) beabstandeten Magnete (4, 4b, d) größer ist, als die Anziehungskraft des oder der näher zum Tastkopfende (210, 220) angeordneten Magnete (4, 4a, c).

## Claims

1. A measuring instrument (1), in particular a voltage tester, having two probes (11, 12), which are arranged in separate housings (21, 22), and having a cable (3), on which the housings (21, 22) are arranged,
wherein the voltage tester, in particular the housings (21, 22) thereof, are implemented as magnetically attractive, wherein either a magnet (4) is arranged on at least one of the housings (21, 22), and at least a part of the other housing (21, 22) is manufactured from a magnetically conductive material, or respectively at least one magnet (4a-d) is provided on each of the housings (21-22), the magnets (4a-d) are provided with opposite polarization to one another, wherein recesses (41) are provided in the housing sheath corresponding to the arrangement of the magnets (4, 4a, b) on the other housing (21), wherein the housings (21, 22) each have a probe end (210, 220), on each of which the probes (11, 12) are accessible,
**characterized in that** a rolling away edge (211, 221) is provided on the probe ends (210, 220) of both housings (21, 22), wherein the rolling away edges (211, 221) are implemented as corresponding to one another and allow rolling of the housings (21, 22) away from one another.

2. The measuring instrument (1) according to Claim 1, **characterized in that** either the magnetically conductive part of the other housing (21), or other magnets (4c, d), which have opposite polarization, on the other housing (21) are accessible through the recesses (41).

3. The measuring instrument (1) according to one of the preceding claims, **characterized in that** the recesses (41) each have the same distance (222, 223) from the probe end (210, 220) as the magnet (4, 4a, b) corresponding thereto.

4. The measuring instrument (1) according to Claim 1, **characterized in that** the housings (21, 22) can be rolled away from one another at the rolling away edges (211, 221) around a rolling away axis (6).

5. The measuring instrument (1) according to Claim 1, **characterized in that** at least one magnet (4a-d) is respectively provided on each of the housings (21, 22), wherein the magnets (4a-d) are provided with opposite polarization to one another, and wherein the magnets (4a-d) are arranged corresponding to one another on the housings (21, 22).

6. The measuring instrument (1) according to one of the preceding claims, **characterized in that** two magnets (4, 4a-d) spaced apart from one another are provided respectively on one or both housings (21, 22).

7. The measuring instrument (1) according to one of the preceding claims, **characterized in that** the attraction force of the magnet or magnets (4, 4b, d) spaced apart farther from the probe end (210, 220) is greater than the attraction force of the magnet or magnets (4, 4a, c) arranged closer to the probe end (210, 220).

## Revendications

1. Instrument de mesure (1), notamment contrôleur de tension comportant deux têtes de détection (11, 12) dans des boîtiers séparés (21, 22) ainsi qu'un câble (3) reliant les boîtiers (21, 22),
- le contrôleur de tension, notamment ses boîtiers (21, 22) étant réalisés de façon à s'attirer par aimantation,
- au moins l'un des boîtiers (21, 22) comporte un aimant (4) ou au moins une partie de l'autre boîtier (21, 22) est en une matière magnéto-conductrice ou encore chacun des boîtiers (21, 22) comporte un aimant (4a-d),
- les aimants (4a-d) ayant des polarités opposées,
- en correspondance avec la disposition des aimants (4, 4a, 4b), l'autre boîtier respectif (21) comporte des cavités (41) dans l'enveloppe de son boîtier,
- les boîtiers (21, 22) ayant chacun une extrémité de tête de détection (210, 220) par lesquelles on arrive aux têtes de détection (11, 12),
**caractérisé en ce que**
l'extrémité de la tête de détection (210, 220) des deux boîtiers (21, 22) comporte une arête de roulement (211, 221),
- les arêtes de roulement (211, 221) étant réalisées de façon correspondante et permettant le roulement des boîtiers (21, 22) l'un par rapport à l'autre.

2. Instrument de mesure (1) selon la revendication 1,
**caractérisé en ce que**
par les cavités (41), l'extrémité magnéto-conductrice de l'autre boîtier (21) est accessible ou encore on a d'autres aimants de polarité opposée (4c, d) de l'autre boîtier (21).

3. Instrument de mesure (1) selon l'une des revendications précédentes,
**caractérisé en ce que**
les cavités (41) sont à la même distance (222, 223) des extrémités de tête de détection (210, 220) respectives, que l'aimant qui leur correspond (4, 4a, b).

4. Instrument de mesure (1) selon la revendication 1,
**caractérisé en ce que**
les boîtiers (21, 22) peuvent rouler sur les arêtes de roulement (211, 221) autour d'un axe de roulement (6) l'une par rapport à l'autre.

5. Instrument de mesure (1) selon la revendication 1,
**caractérisé en ce que**
chacun des boîtiers (21, 22) comporte au moins un aimant (4a-d),
les aimants (4a-d) sont polarisés en sens opposé et
les aimants (4a-4d) sont installés de façon correspondante l'un par rapport à l'autre sur les boîtiers (21, 22).

6. Instrument de mesure (1) selon l'une des revendications précédentes,
**caractérisé en ce que**
l'un ou les deux boîtiers (21, 22) ont chaque fois deux aimants (4, 4a-d) écartés l'un de l'autre.

7. Instrument de mesure (1) selon l'une des revendications précédentes,
**caractérisé en ce que**
la force d'attraction du ou des aimants (4, 4b, d) les plus éloignés de l'extrémité de la tête de détection (210, 220) est plus forte que la force d'attraction du ou des aimants (4, 4a, c) proches de l'extrémité de la tête de détection (210, 220).
